# EUROPEAN PATENT APPLICATION

(11) **EP 1 718 137 A2**
(43) Date of publication of application: **02.11.2006**
(21) Application number: 06002676.2
(22) Date of filing: 09.02.2006
(51) Int. Cl.: H05K 1/14, H05K 3/36

(54) **Three-dimensional circuit module and method of manufacturing the same**

(30) Priority: 16.02.2005 JP 2005039444
(71) Applicant: ALPS ELECTRIC CO., LTD., Tokyo 145-8501 (JP)
(72) Inventor: Miyazawa, Satoshi, Ota-ku Tokyo 145-8501 (JP)
(74) Representative: Klunker . Schmitt-Nilson . Hirsch

(57) **Abstract**

A three-dimensional circuit module has a three-dimensional structure in which a second board is bonded to a first board at a predetermined angle. The first board has a first notched concave part formed at an edge to be a bonding surface S1 and a second notched concave part formed at an edge of the first notched concave part in the depth direction thereof. The second board has an electronic component mounted on a surface thereof opposite to the bonding surface of the first board and is engaged with the first notched concave part in a state in which the electronic component is disposed in the second notched concave part.

## Description

### BACKGROUND OF THE INVENTION

### 1. Field of the Invention

The present invention relates to a three-dimensional circuit module in which an electronic component is mounted on a wiring board having a three-dimensional structure and a method of manufacturing the same.

### 2. Description of the Related Art

Recently, a three-dimensional circuit module has been proposed in which a wiring circuit is three-dimensionally formed on a board with a three-dimensional structure and an electronic component, a functional element, and the like are mounted thereon. For example, in a case of a three-dimensional sensing module, a three-dimensional wiring board having two plane perpendicular to each other is prepared, and three magnetic sensors each having a function of performing sensing in one axis direction are arranged such that two magnetic sensors performing sensing in X and Y axis directions are disposed on one plane and another magnetic sensor performing sensing in a Z axis direction is disposed on the other plane. Therefore, it is possible to performing three-dimensional sensing in the X, Y, and Z axis directions as well as planar sensing in the X and Y directions.

However, such a three-dimensional sensing module is mounted in a small-sized portable electronic apparatus, and therefore it needs to further reduce the size. In particular, at the time of manufacturing the three-dimensional sensing module, since it is necessary to mount the above-mentioned magnetic sensor even in the three-dimensional Z-axis direction, it is preferable to manufacture the wiring board having minute and three-dimensional wiring lines with high precision at low cost.

As a method of manufacturing such a three-dimensional circuit module, for example, a method has been proposed in which a wiring board having a three-dimensional shape is prepared by, for example, resin molding, the wiring board is three-dimensionally wired, and then electronic components are mounted (see JP-A-6-164105). However, in the manufacturing method disclosed in JP-A-6-164105, since a planar wiring process according to the related art has been performed on a printed circuit board or a flexible wiring board cannot be used, a process of three-dimensionally forming wiring lines becomes complicated. Further, in a mounting process, since it is difficult to directly mounting electronic components on a vertical surface, it is necessary to performing separate mounting processes on two planes which have a vertical positional relationship therebetween, respectively. Therefore, in the manufacturing method, the manufacturing process becomes long and complicated and the manufacturing cost increases.

Meanwhile, a method has been proposed in which one wiring board with components mounted thereon is bonded in perpendicular to another wiring board with another components mounted thereon (see JP-A-2000-274274). However, in the manufacturing method disclosed in JP-A-2000-274274, it is difficult to precisely bond a bonding edge of the one wiring board perpendicular to the other wiring board. Therefore, in order to precisely perform the vertical correction of the wiring boards, it is necessary to add a new circuit for detecting the deviated amount of the angle of each of the magnetic sensors mounted in X, Y, and Z axis directions with respect to the vertical direction and correcting the deviation. As a result, even in this manufacturing method, the manufacturing process becomes long and complicated and the manufacturing cost increases.

### SUMMARY OF THE INVENTION

The invention has been finalized in view of the inherent drawbacks in the related art, and it is an object of the invention to provide a three-dimensional circuit module that has a three-dimensional structure in which a second board is bonded to a first board at a predetermined angle, can precisely and easily perform angle correction of an electronic component mounted, and can reduce the entire module size.

Further, it is another object of the invention to provide a method of manufacturing such a three-dimensional circuit module that simplifies the manufacturing process of the three-dimensional circuit module and remarkably improves the productivity.

In order to achieve the above-mentioned objects, according to a first aspect of the invention, a three-dimensional circuit module is provided which includes a first board and a second board each having at least one surface with wiring lines formed thereon and has a three-dimensional structure in which the second board is bonded to the first board at a predetermined angle so as to form a wiring circuit in which the wiring lines of the first and second boards are connected to each other. In the three-dimensional circuit module, the first board has a first notched concave part formed at an edge to be a bonding surface and a second notched concave part formed at an edge of the first notched part in the depth direction of the first notched part and the second board has an electronic component mounted on an surface opposite to the bonding surface of the first board. The second board is engaged with the first notched concave part in a state in which the electronic component is disposed in the second notched concave part.

In the three-dimensional circuit module according to the first aspect of the invention, the bonding surface of the first board and a bonding surface of the second board may be bonded to each other by an adhesive.

Further, in the three-dimensional circuit module according to the first aspect of the invention, metal bump or conductive paste may provided to the boundary where the wiring lines of the first board facing the bonding surface of the first board and the wiring lines on the bonding surface of the second board are brought into contact with each other, and may electrically connect the wiring lines of the first board and the wiring lines of the second board to each other.

Furthermore, in the three-dimensional circuit module according to the first aspect of the invention, it is preferable that at least the first board of the first and second boards be formed by injection molding.

Furthermore, in the three-dimensional circuit module according to the first aspect of the invention, it is preferable that the first board be thicker than the second board.

Furthermore, in the three-dimensional circuit module according to the first aspect of the invention, it is preferable that the surfaces of the first and second boards on which the wiring lines are formed be flat.

Furthermore, in the three-dimensional circuit module according to the first aspect of the invention, the predetermined angle may be 90°.

According to a second aspect of the invention, a method of manufacturing a three-dimensional circuit module is provided which includes a first board and a second board each having at least one surface with wiring lines formed thereon and has a three-dimensional structure in which the second board is bonded to the first board at a predetermined angle so as to form a wiring circuit in which the wiring lines of the first and second boards are connected to each other. The method includes the steps of: forming a first mother board where a plurality of parts each to be the first board are arranged in a matrix by forming the wiring lines on every part to be the first board, forming first slits at predetermined intervals along boundary lines where the parts to be the first boards are parallel to a first direction, and second slits at predetermined intervals along boundary lines where the parts to be the first boards are parallel to a second direction perpendicular to the first direction, and forming a first notched concave part at an edge on the side to be bonding surface of each first board and a second notched concave part at an edge of each first notched concave part in the thickness direction of the first notched concave part; forming a second mother board where a plurality of parts each to be the second board are arranged in a matrix by forming the wiring lines at every part to be the second board, forming third slits at predetermined intervals along boundary lines where the parts to be the second boards are parallel to a third direction, and fourth slits at predetermined intervals along boundary lines where the parts to be the second boards are parallel to a fourth direction perpendicular to the third direction, and by mounting an electronic component or electronic components at each part to be the second board; bonding the second mother board to the first mother board at a predetermined angle in a state in which the parts of the second mother board to be the second boards are engaged with the first notched concave parts such that the electronic components are disposed in the second notched concave parts; forming a three-dimensional circuit block where three-dimensional circuit modules are arranged in a row by cutting out the part of the first mother board bonded to the second mother board along the first slits of the bonded part from the first mother board and cutting out the part of the second mother board bonded to the first mother board along the third slits form the second mother board; and dividing the three-dimensional circuit block into individual three-dimensional circuit modules by cutting the three-dimensional circuit block along the second and fourth slits.

In the method of manufacturing a three-dimensional circuit module according to the second aspect of the invention, before the bonding step, at least a row board where the parts of the second mother board to be the second boards are arranged in a row may be cut out along the third slits from the second mother board. Further, in the bonding step, the row board may be bonded to the first mother board at a predetermined angle in a state in which the parts of the row board to be the second boards are engaged with the first notched concave parts such that the electronic components are disposed in the second notched concave parts. Furthermore, in the three-dimensional circuit block forming step, it is possible that the three-dimensional block is manufactured by cutting out the part of the first mother board bonded to the row board along the first slits of the bonded part from the first mother board.

Further, the method of manufacturing a three-dimensional circuit module according to the second aspect of the invention, the bonding step, the three-dimensional circuit block forming step, and the dividing step may be sequentially repeated.

Furthermore, in the method of manufacturing a three-dimensional circuit module according to the second aspect of the invention, it is preferable that the first slits be formed between the boundary lines parallel to the second direction in the first mother board forming step.

Furthermore, in the method of manufacturing a three-dimensional circuit module according to the second aspect of the invention, it is preferable that the third slits be formed at both sides of each of the parts to be the second boards in the second mother board forming step.

Furthermore, in the method of manufacturing a three-dimensional circuit module according to the second aspect of the invention, it is preferable that protrusions be formed between the first slits such that the protrusions are brought into contact with the surfaces of the parts to be the second boards opposite to the surfaces on which the electronic components are mounted when the parts to be the second boards are engaged with the first notched concave parts.

Furthermore, in the method of manufacturing a three-dimensional circuit module according to the second aspect of the invention, the first mother board may be bonded to the second mother board or the row board by an adhesive in the bonding.

Furthermore, in the method of manufacturing a three-dimensional circuit module according to the second aspect of the invention, it is possible that, in the bonding step, metal bump or conductive paste is formed at the boundary where the wiring lines of the first board facing the bonding surface of the first board and the wiring lines on the bonding surface of the second board are brought into contact with each other, and electrically connects the wiring lines of the first board and the wiring lines of the second board to each other.

Furthermore, in the method of manufacturing a three-dimensional circuit module according to the second aspect of the invention, it is preferable that at least the first mother board of the first and second mother boards be formed by injection molding.

Furthermore, in the method of manufacturing a three-dimensional circuit module according to the second aspect of the invention, it is preferable that the first mother board be thicker than the second mother board.

Furthermore, in the method of manufacturing a three-dimensional circuit module according to the second aspect of the invention, it is preferable that the surfaces of the first and second mother boards on which the wiring lines are formed be flat.

Furthermore, in the method of manufacturing a three-dimensional circuit module according to the second aspect of the invention, the predetermined angle in the bonding step may be 90°.

### BRIEF DESCRIPTION OF THE DRAWINGS

Fig. 1 is a perspective view showing a three-dimensional sensing module according to the invention;
Fig. 2 is an exploded perspective view showing the three-dimensional sensing module shown in Fig 1;
Fig. 3 is a perspective view showing a first wiring board as seen from a bonding surface side;
Fig. 4 is a perspective view showing a state in which a first mother board is manufactured in a first mother board manufacturing process for explaining a process of manufacturing the three-dimensional sensing module shown in Fig. 1;
Fig. 5 is a perspective view showing a state in which a first mother wiring board is manufactured in the first mother board manufacturing process for explaining the process of manufacturing the three-dimensional sensing module shown in Fig. 1;
Fig. 6 is a perspective view showing a state in which a second mother board is manufactured in a second mother board manufacturing process for explaining the process of manufacturing the three-dimensional sensing module shown in Fig. 1;
Fig. 7 is a perspective view showing a state in which a second mother wiring board is manufactured in the second mother board manufacturing process for explaining the process of manufacturing the three-dimensional sensing module shown in Fig. 1;
Fig. 8 is a perspective view showing a state before the second mother wiring board is bonded to the first mother wiring board in a bonding process for explaining the process of manufacturing the three-dimensional sensing module shown in Fig. 1;
Fig. 9 is a perspective view showing a state in which the second mother wiring board is bonded to the first mother wiring board in the bonding process for explaining the process of manufacturing the three-dimensional sensing module shown in Fig. 1;
Fig. 10 is an enlarged perspective view of the bonded portion between the first mother wiring board and the second mother wiring board shown in Fig. 8;
Fig. 11 is an enlarged perspective view of the bonded portion between the first mother wiring board and the second mother wiring board shown in Fig. 9;
Fig. 12 is a perspective view showing a state in which a three-dimensional circuit block is manufactured in a block manufacturing process for explaining the process of manufacturing the three-dimensional sensing module shown in Fig. 1;
Fig. 13 is a perspective view showing a state in which the three-dimensional circuit block is divided into individual three-dimensional sensing modules in a dividing process for explaining the process of manufacturing the three-dimensional sensing module shown in Fig. 1; and
Fig. 14 is a perspective view for explaining the process of manufacturing the three-dimensional sensing module shown in Fig. 1.

### DESCRIPTION OF THE PREFERRED EMBODIMENT

Hereinafter, a three-dimensional circuit module and a method of manufacturing the same according to the invention will be described in detail with reference to the accompanying drawings. Sizes or materials of individual parts exemplified in the following description are just examples, and the invention is not necessary to be limited thereto.

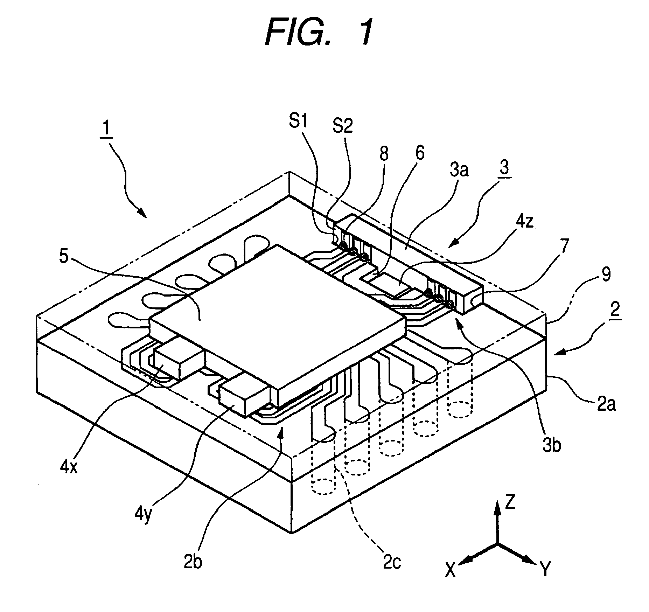

The three-dimensional circuit module according to the invention is, for example, a three-dimensional sensing module 1 shown in Fig. 1. The three-dimensional sensing module 1 is constructed to be capable of three-dimensionally sensing by forming a three-dimensional wiring circuit on surfaces of wiring boards 2 and 3 having a three-dimensional structure and by disposing three magnetic sensors 4x, 4y, and 4z, each having a function of performing sensing in one axis direction as an electronic component, in X, Y, and Z axis directions, respectively.

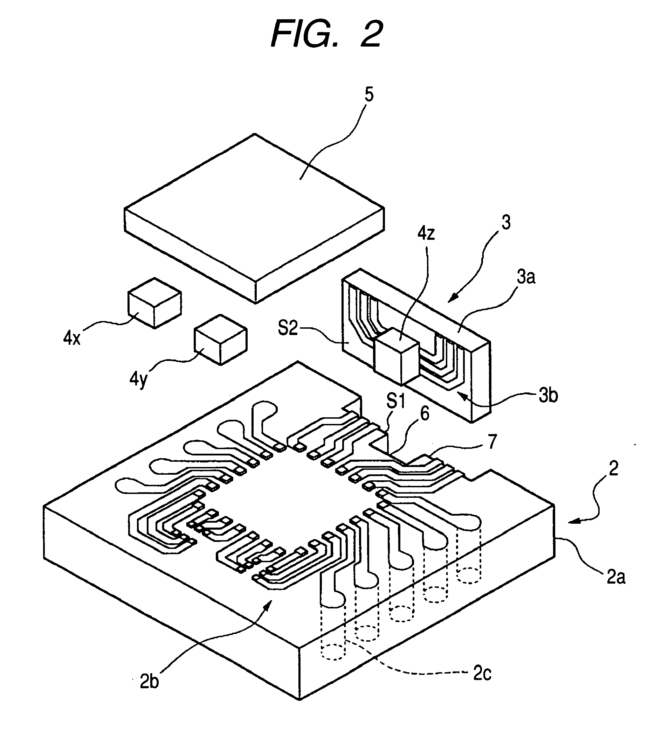

In particular, the three-dimensional sensing module 1 is provided with a first wiring board 2 and a second wiring board 3 bonded to the first wiring board 2 as shown in Figs. 1 and 2.

The first wiring board 2 has a first insulating resin substrate 2a that is formed into a substantially rectangular shape by injection molding and first wiring patterns 2b formed on two surface of the first insulating resin substrate 2a, and the wiring patterns 2b on the two surfaces are electrically connected to each other by through-holes 2c passing though the insulating resin substrate 2a in the thickness direction thereof. Further, one surface of the first wiring board 2 is flat, and the two magnetic sensors 4x and 4y among three magnetic sensors which perform the sensing in the X and Y axis directions and a IC chip 5 for processing signals detected by the magnetic sensors 4x, 4y, and 4z are mounted on the flat surface. These two magnetic sensors 4x and 4y and the IC chip 5 are connected to terminals of the first wiring patterns 2b in a flip-chip manner, respectively, and are electrically connected to each other by the first wiring patterns 2b.

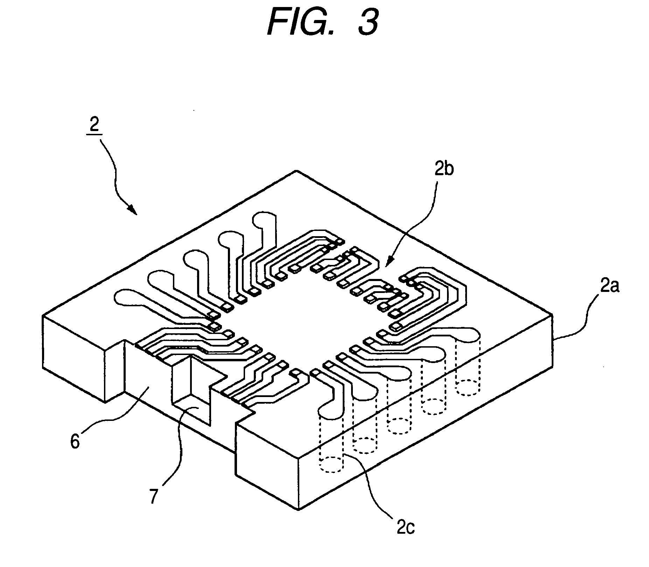

Further, a first notched concave part 6 is formed in one edge of the first wiring board 2 as shown in Fig. 3 so as to be engaged with the second wiring board 3. The first notched concave part 6 is formed by cutting out the substantially middle part of the edge of the first wiring board 2 in the thickness direction thereof so as to have a width and a depth enough to be engaged with the second wiring board 3. Furthermore, in this embodiment, the first notched concave part 6 is formed into a shape corresponding to the second wiring board 3 so that the second wiring board 3 is fitted into the first notched concave part 6. However, if the second wiring board 3 is engaged with the first notched concave part 6, the first notched concave part 6 can be formed larger than the second wiring board 3.

Furthermore, a second notched concave part 7 to be described below is formed on an edge (bottom) of the first notched concave part 6 in the depth direction thereof so as to contain the magnetic sensor 4z mounted on the second wiring board 2. The second notched concave part 7 is formed by cutting out the substantially middle part of the bottom of the first notched concave part 6 in the thickness direction of the first wiring board 2 so as to have a width and a depth enough to contain the magnetic sensor 4z therein. In this embodiment, the second notched concave part 7 is formed larger than the magnetic sensor 4z so as to contain the magnetic sensor 4z. If the second notched concave part 7 contains at least a part of the magnetic sensor 4z, the second notched concave part 7 can be notched smaller than the magnetic sensor 4z. Further, the second notched concave part 7 can be formed into a shape corresponding to the magnetic sensor 4z such that the magnetic sensor 4z is fitted into the second notched concave part 7.

Meanwhile, the second wiring board 3 is provided with a second insulating resin substrate 3a formed into a substantially rectangular plate shape by injection molding, and a second wiring pattern 3b formed on one surface of the second insulating resin substrate 3a, as shown in Figs. 1 and 2. The surface of the second wiring board 3 on which the second wiring pattern 3b is formed is flat and the magnetic sensor 4z performing the sensing in the Z-axis direction is formed on the flat surface. The magnetic sensor 4z is connected to terminals of the second wiring pattern 3b in the flip-chip manner.

The three-dimensional sensing module 1 has a three-dimensional structure in which the second wiring board 3 is bonded to the first wiring board 2 at right angle (90°) so as to form a wiring circuit in which the first and second wiring patterns 2b and 3b are connected to each other as shown in Fig. 1.

In particular, in the three-dimensional sensing module 1, the second wiring board 3 is engaged with the first notched concave part 6 in a state in which the magnetic sensor 4z mounted on the second wiring board 3 is disposed in the second notched concave part 7. Further, a bonding surface S1 of the first wiring board 2 is bonded with a bonding surface S2 of the second wiring board 3 by an adhesive. Furthermore, the wiring patterns 2b on the bonding surface S1 of the first wiring board 2 and the second wiring pattern 3b on the bonding surface S2 of the second wiring board 3 are electrically connected to each other by a metal bump or conductive paste 8 provided at the boundary therebetween. In this way, the IC chip 5 on the first wiring board 2 and the magnetic sensor 4z on the second wiring board 3 are electrically connected to each other by the first and second wiring patterns 2b and 3b. Further, the top of the first wiring board 2 to which the second wiring board 3 is bonded is sealed by a sealant 9 for protecting the magnetic sensors 4x, 4y, and 4z and the IC chip 5. Furthermore, the bonding surface S1 of the first wiring board 2 is mainly an edge of the second notched concave part 7 in the depth direction thereof, and the bonding surface S2 of the second wiring board 3 is mainly a surface of the second wiring board 3 on which the second wiring pattern 3b is formed.

In the three-dimensional sensing module 1 having the above-mentioned construction, among the three magnetic sensors 4x, 4y, and 4z each having a function of performing sensing in one axis direction, the magnetic sensors 4x and 4y disposed on the first wiring board 2 perform sensing in the X and Y axis directions perpendicular to each other, respectively, and the magnetic sensor 4z disposed on the second wiring board 3 perform sensing in the Z-axis direction perpendicular to the X and Y axis directions. Therefore, the three-dimensional sensing module can perform three-directional sensing.

Further, the three-dimensional sensing module 1 can be mounted in a small-sized portable electronic apparatus or the like as one functional part. In particular, the terminals of the first wiring patterns 2b formed on the other surface of the first wiring board 2 of the three-dimensional sensing module 1 are connected to a wiring pattern formed on a circuit board of an apparatus (not shown) in the flip-chip manner. In this way, the three-dimensional sensing module 1 can be surface-mounted on the circuit board of the apparatus.

Meanwhile, in order to accurately perform three-dimensional sensing using the three-dimensional sensing module 1, it is necessary to precisely correct an angle of the magnetic sensor 4z performing sensing in the Z-axis direction. Specifically, it is necessary to accurately bond the second wiring board 3 provided with the magnetic sensor 4z to the first wiring board 2 provided with the magnetic sensors 4x and 4y performing sensing in the X and Y axis directions at a right angle (90°).

In the three-dimensional module 1 according to the invention, as described above, the second wiring board 3 is engaged with the first notched concave part 6 of the first wiring board 2 in a state in which the magnetic sensor 4z mounted on the second wiring board 3 is disposed in the second notched concave part 7. In this way, it is possible to accurately bond the second wiring board 3 to the first wiring board 2 at a right angle (90°). Further, two side surfaces of the second notched concave part 7 hold two edges of the second wiring board 2 in the length direction of the second wiring board 2, and thus it is possible to reliably correct the angle of the second wiring board 3 with respect to the first wiring board 2.

Further, in the three-dimensional sensing module 1, it is preferable that at least the first wiring board 2 of the first and second wiring boards 2 and 3 be formed by injection molding. In this case, it is possible to accurately form the bonding surface S1 of the first wiring board 2 according to the bond angle. Further, even when the second wiring board 3 is formed by injection molding, it is possible to further planarize the bonding surface S2 of the second wiring board 3.

Furthermore, in the three-dimensional sensing module 1, it is preferable that the first wiring board 2 be thicker than the second wiring board 3. In this case, the bonded area between the bonding surface S1 of the first wiring board 2 and the bonding surface S2 of the second wiring board 3 becomes larger. Therefore, it is possible to reliably correct the angle of the second wiring board 3 with respect to the first wiring board 2.

As described above, in the three-dimensional sensing module 1 according to the invention, it is possible to precisely and easily correct the angle of the above-mentioned magnetic sensor 4z. Therefore, it is possible to accurately perform the three-dimensional sensing using three-dimensional sensing module 1.

Further, in the three-dimensional sensing module 1 according to the invention, since the magnetic sensor 4 is disposed within the second notched concave part 7, it is possible to preventing the height dimension of the entire module from increasing. Furthermore, since it is not necessary to add a circuit for detecting the deviated amount of the angle of each of the magnetic sensors 4x, 4y, and 4z mounted in the X, Y, and Z axis directions to correct the derived angle, it is possible to further reduce the size of the above-mentioned IC chip 5. Therefore, it is possible to remarkably reduce the size of the entire three-dimensional sensing module 1.

Next, a method of manufacturing a three-dimensional circuit module according to the invention will be described with an example of a case of manufacturing the above-mentioned three-dimensional sensing module 1.

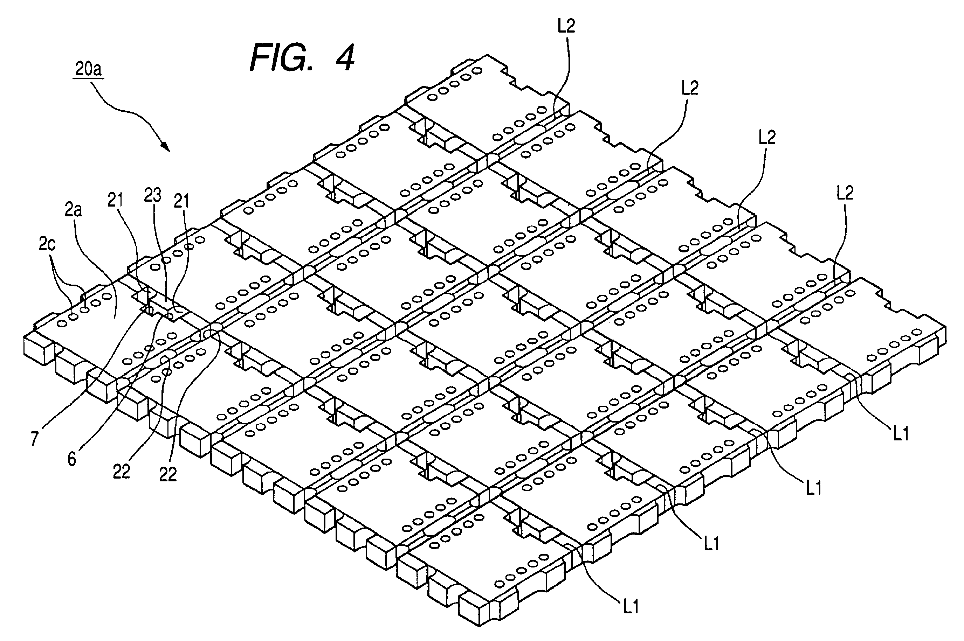

As shown in Figs. 4 to 13, the method of manufacturing a three-dimensional circuit module according to the invention includes a first mother wiring board manufacturing process of manufacturing a first mother wiring board 20 where a plurality of parts, each to be the first wiring board 2, are arranged in a matrix; a second mother wiring board manufacturing process of manufacturing a second mother wiring board 30 where a plurality of parts, each to be the second wiring board 3, are arranged in a matrix; a second mother wiring board bonding process of bonding the second mother wiring board 30 to the first mother wiring board 20 at 90°; a three-dimensional circuit block manufacturing process of manufacturing a three-dimensional circuit block 40 in which the three-dimensional sensing modules 1 are formed in a row by cutting off a part in which the first mother wiring board 20 and the second mother wiring board 30 are bonded to each other from the first and second mother wiring boards 20 and 30; dividing the three-dimensional block 40 into the individual three-dimensional sensing modules 1. According to the method, it is possible to manufacture a plurality of three-dimensional sensing modules 1 through the above processes at once.

In particular, in the first mother wiring board manufacturing process, first, the first mother board 20a having a shape shown in Fig. 4 is formed by injection molding. The first mother board 20a has a substantially rectangular plate shape as a whole, and has a construction in which a plurality of parts, each to be the first insulating resin substrate 2a, are arranged in a matrix to be connected to each other. The first mother board 20a is made of, for example, poly phenylene sulfide (PPS) and the thickness of the first mother board 20a is, for example, 0.7 mm. Further, the size of each part to be the first insulating resin substrate 2a is, for example, 3 mm x 3 mm, and the parts, each to be the first insulating resin substrate 2a, are arranged in, for example, a five-by-five matrix (total 5 x 5 = 25).

Further, in the first mother board 20a, first slits 21 are formed into perforated line shape at predetermined intervals along each boundary line L1 where the parts to be the first insulating resin substrate 2a are parallel to a first direction, and second slits 22 are formed into perforated line shape at predetermined intervals along each boundary line L2 where the parts to be the first insulating resin substrate 2a are parallel to a second direction perpendicular to the first direction.

The first slits 21 form a pair between the boundary lines L2 parallel to the second direction. Further, a protrusion 23 protrude from a substantially middle portion of a part opposite to the part to be bonding surface S1 of the first wiring board 2 between each pair of first slits 21.

Meanwhile, the second slits 22 are alternately provided at the middle positions between the boundary lines L1 parallel to the first direction and intersections of the boundary lines L1.

Further, the above-mentioned first notched concave part 6 is formed at each part to be the bonding surface S1 of the first wiring board 2 and the above-mentioned second notched concave part 7 is formed at an edge (bottom) of the first notched concave part 6 in the depth direction thereof. Furthermore, the above-mentioned through-holes 2c are formed at each part to be the first wiring board 2.

In the first mother wiring board manufacturing process, it is possible to accurately manufacture the first mother substrate 20a having the above-mentioned shape by injection molding.

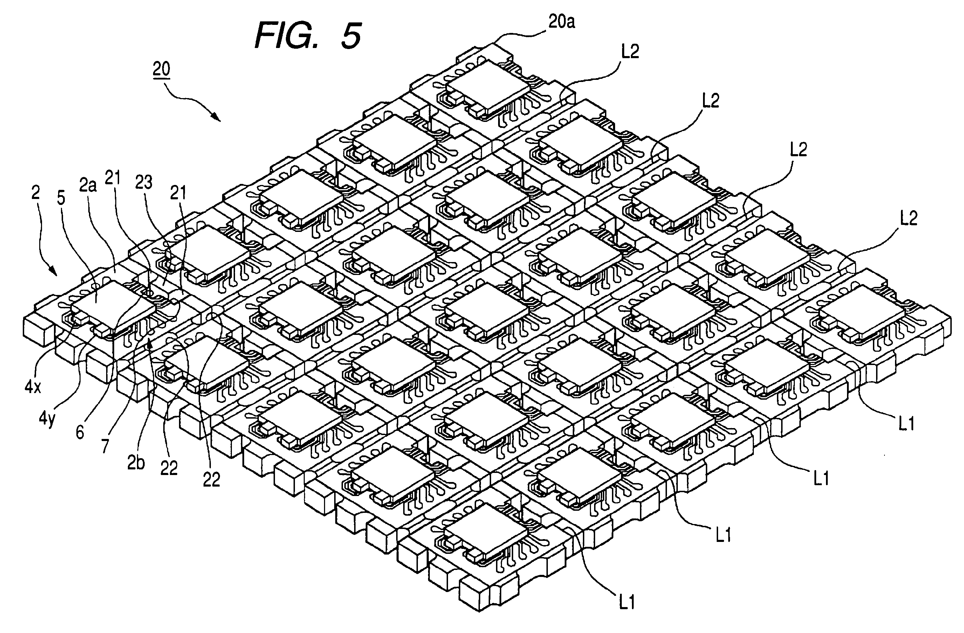

Next, the above-mentioned first wiring patterns 2b are formed on each part of the first mother board 20a to be the first wiring board 2 as shown in Fig. 5.

In particular, first, two surfaces of the first mother board 20a are activated by an Ar plasma process and then functional films having chemical adhesion are formed on the both surfaces of the first mother board 20a by a dipping method. In this way, it is possible to achieve sufficient adhesion without roughening the board surfaces. Next, a copper plating film is formed into, for example, the thickness of 2 µm on two surfaces of the first mother board 20a by an electroless plating method. Subsequently, a resist is coated on the both surfaces of the first mother board 20a by a resist coater and is exposed by a double-sided exposure machine, and then the resist in the exposed parts is dissolved into a developing solution so as to be removed. Next, the copper plating film is etched by a ferric chloride solution by using the remaining resist pattern as a mask, and then the resist pattern is removed. Subsequently, a nickel plating film is formed on the remaining copper plating film by the electroless plating method to have for example, a thickness of 5 µm and then a gold plating film is formed thereon to have, for example, a thickness of 0.1 µm.

In this way, the first wiring patterns 2b are formed on the both surfaces of each part to be the first wiring board 2. Further, the first wiring pattern 2b has, for example, the minimum line width of 30 µm and the minimum gap of 30 µm.

Furthermore, the first wiring patterns 2b formed on the two surfaces are electrically connected to each other by plating or conductive paste buried in the through-holes 3c.

Next, the magnetic sensors 4x and 4y and the IC chip 5 are mounted on one surface of each part to be the first wiring board 2. In particular, the magnetic sensors 4x and 4y, and the IC chip 5, are connected to the terminals of the first wiring patterns 2b in the flip-chip manner by, for example, an NCP (Non Conductive Paste) method. Further, the size of each of the magnetic sensors 4x and 4y is, for example, 0.3 mm x 0.3 mm x 0.2 mm, and the size of the IC chip 5 is, for example, 1.5 mm x 1.5 mm x 0.2 mm.

As described above, the first mother wiring board 20 shown in Fig. 5, in which the plurality of parts, each to be the first wiring board 2, are arranged in a matrix, is manufactured.

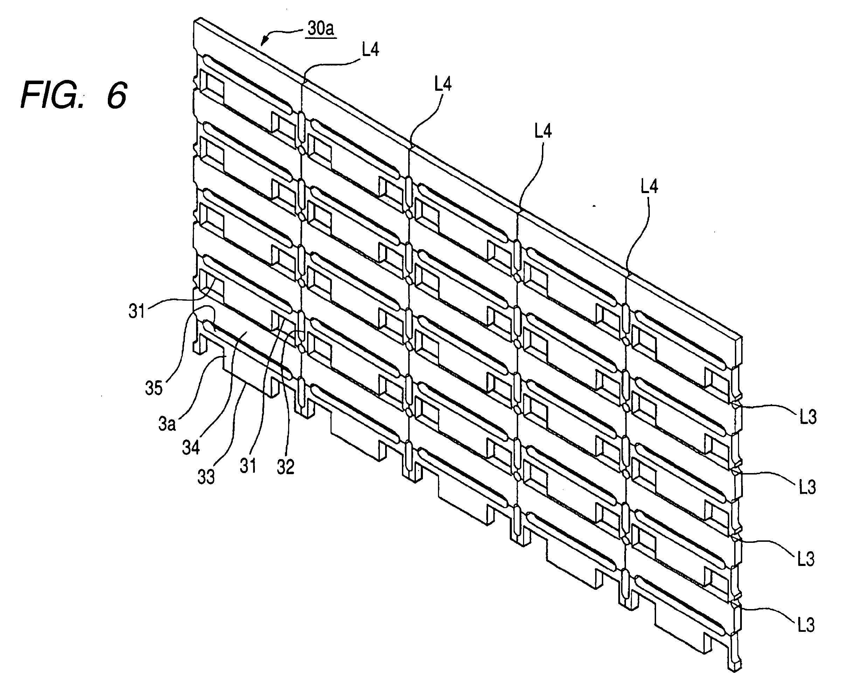

In the second mother wiring board manufacturing process, first, the second mother board 30a having a shape shown in Fig. 6 is formed by injection molding. The second mother board 30a has a substantially rectangular plate shape as a whole, and has a construction in which a plurality of parts, each to be the second insulating resin substrate 3a, are arranged in a matrix to be connected to each other. The second mother board 30a is made of, for example, poly phenylene sulfide (PPS) and a thickness of the second mother board 30a is, for example, 0.2 mm. Further, a size of each part to be the second insulating resin substrate 3a is, for example, 1 mm x 3 mm, and the parts, each to be the second insulating resin substrate 3a, are arranged in, for example, a five-by-five matrix (total 5 x 5 = 25).

Further, in the second mother board 30a, third slits 31 are formed into perforated line shape at predetermined intervals along each boundary line L3 where the parts to be the second insulating resin substrate 3a are parallel to a third direction, and fourth slits 32 are formed into perforated line shape at predetermined intervals along each boundary line L4 where the parts to be the second insulating resin substrate 3a are parallel to a fourth direction perpendicular to the third direction.

The third slits 31 form a pair between the boundary lines L4 parallel to the fourth direction. Further, a connection part 33 formed between each pair of the third slits 31 is to be finally the second wiring board 3, and the pair of third slits 31 are formed such that the connection part 33 is disposed at a substantially middle part therebetween.

Further, in the second mother board 30a, fifth slits 35 are arranged between the connection parts 33 and the remaining parts 34 excluding the connection parts 33 parallel to the third slits 31 at predetermined intervals. The fifth slits 35 are formed to finally cut the connection parts 33 and the remaining parts 34 off from each other and are formed into an elongated shape between the boundary lines L4 parallel to the fourth direction. Further, the width of each connection part 33 is 1 mm and the width of each remaining part 34 is 2 mm.

Meanwhile, the fourth slits 32 are formed between the third slits 31 and the fifth slits 35 along the boundary lines L4 parallel to the fourth direction.

In the second mother wiring board manufacturing process, it is possible to accurately manufacture the second mother substrate 30a having the above-mentioned shape by injection molding.

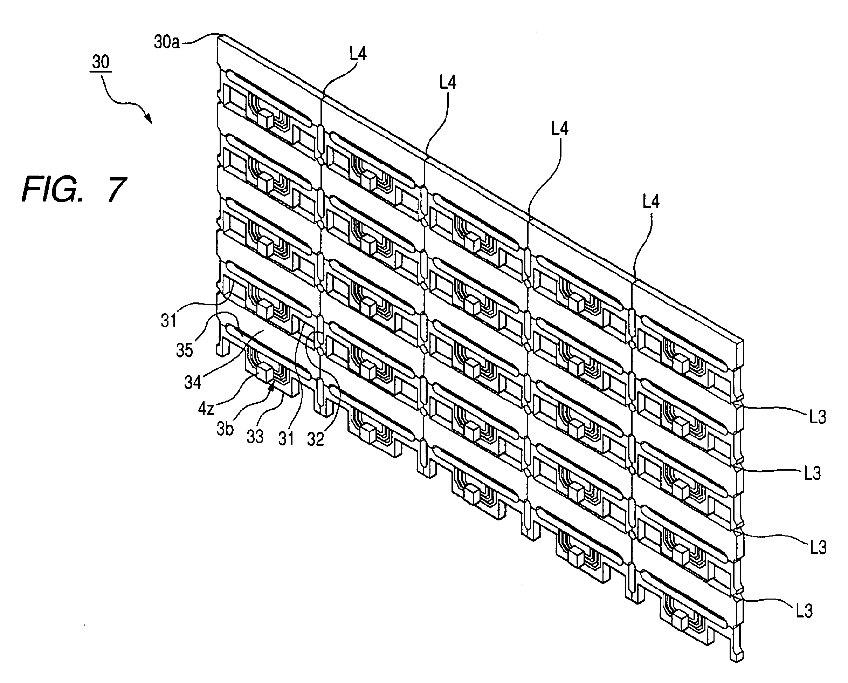

Next, the above-mentioned second wiring pattern 3b is formed at each part of the second mother board 30a to be the second wiring board 3, as shown in Fig. 7.

In particular, first, one surface of the second mother board 30a is activated by an Ar plasma process and then functional films having chemical adhesion are formed on the surface of the second mother board 30a by a dipping method. In this way, it is possible to achieve sufficient adhesion without roughening the board surface. Next, a copper plating film is formed on the surface of the second mother board 30a by the electroless plating method to have, for example, the thickness of 2 µm. Subsequently, a resist is coated on the surface of the second mother board 30a by a resist coater and is exposed by a double-sided exposure machine, and then the resist in the exposed parts is dissolved into a developing solution so as to be removed. Next, the copper plating film is etched by a ferric chloride solution by using the remaining resist pattern as a mask, and then the resist pattern is removed. Subsequently, a nickel plating film is formed on the remaining copper plating film by the electroless plating method to have, for example, the thickness of 5 µm and then a gold plating film is formed thereon to have, for example, the thickness of 0.1 µm.

In this way, the second wiring pattern 3b is formed on one surface of the connection part 34 to be the second wiring board 3. Further, the second wiring pattern 3b has, for example, the minimum line width of 30 µm and the minimum gap of 30 µm.

Next, the magnetic sensor 4z is mounted on the surface of the connection part 34 to be the second wiring board 3 on which the second wiring pattern 3b has been formed. In particular, the magnetic sensor 4z and the terminals of the second wiring pattern 3b are connected to each other in the flip-chip manner by, for example, the NCP (Non Conductive Paste) method. Further, the size of the magnetic sensor 4z is, for example, 0.3 mm x 0.3 mm x 0.2 mm which is the same as those of the magnetic sensors 4x and 4y.

As described above, the second mother wiring board 30 shown in Fig. 7 is manufactured in which the plurality of parts, each to be the second wiring board 3, are arranged in a matrix.

In the bonding process, first, the first mother wiring board 20 is mounted on a jig (not shown) having a plurality of guide pins which stand vertically. At this time, the plurality of guide pins are inserted into the plurality of second slits 22 parallel to the second direction and are pressed against edges on one side in the second slits 2 such that the second mother wiring board 30 to which surfaces of the guide pins on the other side are exactly bonded is guided to a predetermined position. In this way, it is possible to accurately perform the positioning of the second mother wiring board 30 with regard to the first mother wiring board 20 by using the guide pins inserted into the second slits 22 of the first mother wiring board 20.

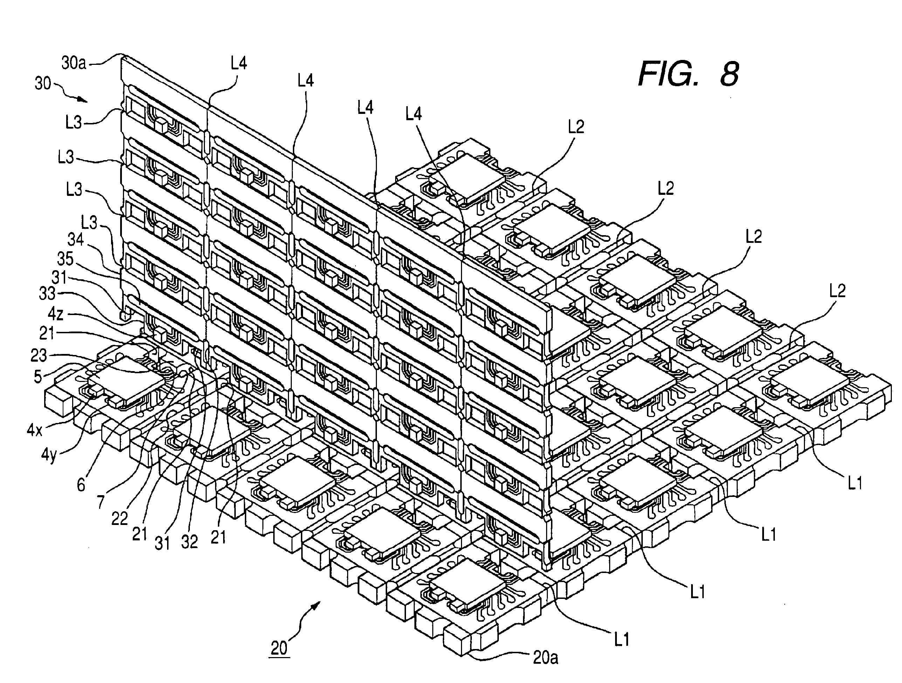

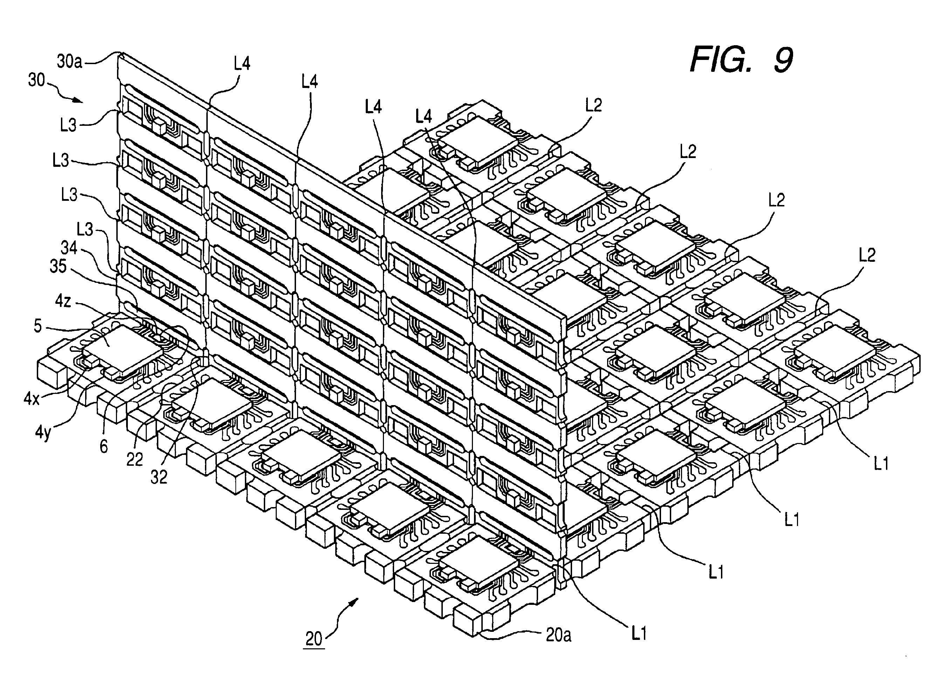

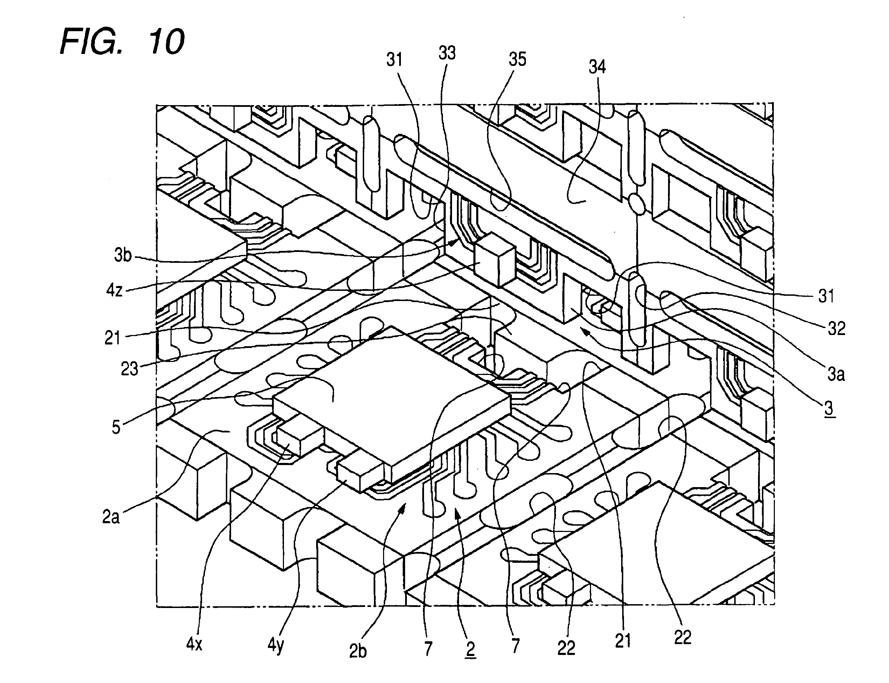

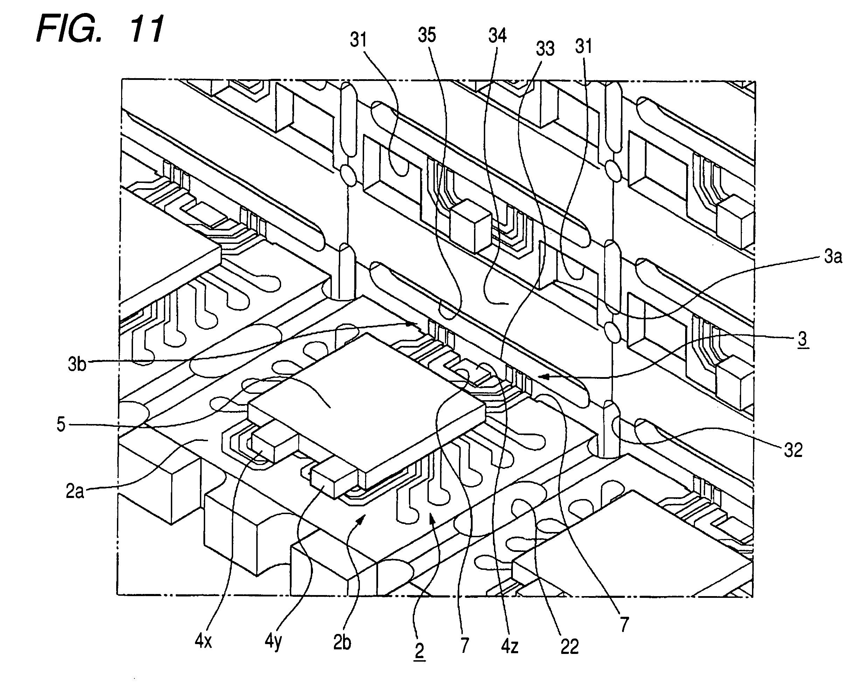

Next, as shown in Figs. 8 and 9, the second mother wiring board 30 is bonded to the first mother wiring board 20 at 90°. In particular, in order to change from the state shown in Fig. 10 to the state shown in Fig. 11, the connection parts 34 of the second mother wiring board 30 are engaged with the second notched concave parts 6 such that the magnetic sensors 4z mounted on the connection parts 34 are disposed in the second notched concave parts 7. At this time, the connection parts 34 is obtained by cutting the second mother wiring board 30 along the third slits 31 to protrude from the third slits 31 of the cutting surface along the boundary lines L3. Further, an appropriate amount of adhesive is coated on the interface between the first mother wiring board 20 and the second mother wiring board 30 in advance. The adhesive may include, for example, epoxy adhesive, cyanoacrylate adhesive, etc.

Here, the connection part 34 is fitted into the second notched concave part 7. In particular, the surface of the connection part 34 on which the magnetic sensor 4z is mounted is brought into contact with the bottom of the second notched concave part 7, two edges of the connection part 34 in the longitudinal direction thereof are brought into contact with two side surfaces of the second notched concave part 7, and the surface of the connection part 34 opposite to the surface on which the magnetic sensor 4z is mounted is brought into contact with the protrusion 23. Therefore, the connection part 4 is supported by total four surfaces. In this way, it is possible to prevent displacement between the first mother wiring board 20 and the second mother wiring board 30 until the adhesive becomes hardened, and thus it is possible to stably maintain the bonded state in which the second mother wiring board 30 is bonded to the first mother wiring board 20 at 90°.

Further, since the first mother wiring board 20 is formed thicker than the second mother wiring board 30, the bonded area between the bonding surface of the first mother wiring board 20 and the bonding surface of the second mother wiring board 30 increases. Therefore, it is possible to reliably perform the correcting of the angle of the second mother wiring board 30 with respect to the first mother wiring board 20.

Next, after the adhesive becomes hardened, the above-mentioned metal bump or conductive paste 8 is formed at the boundary where the first wiring patterns 2b on the bonding surface S1 of the first mother wiring board 20 and the second wiring pattern 3b on the bonding surface S2 of the second mother wiring board 30 are brought into contact with each other. The metal bump or conductive paste 8 electrically connects the first wiring patterns 2b to the second wiring pattern 3b.

As described above, the second mother wiring board 30 is bonded to the first mother wiring board 20 at 90°.

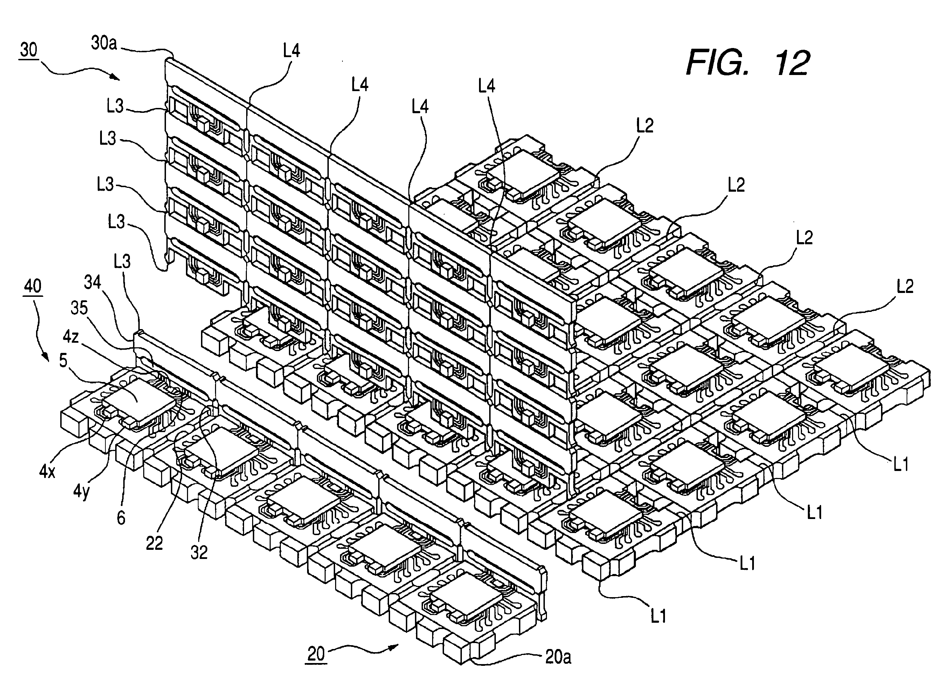

In the three-dimensional circuit block manufacturing process, as shown in Fig. 12, the bonded part of the first mother wiring board 20 to the second mother wiring board 30 is separated from the first mother wiring board 20 by cutting along the first slits 21 of the bonded part, and the bonded part of the second mother wiring board 30 to the first mother wiring board 20 is separated from the second mother wiring board 30 by cutting along the third slits 31 on the opposite side to the bonded part. At this time, since the first slits 21 and the second slits 31 are formed into perforated line shapes, it is possible to easily cut the bonded parts along the boundary lines L1 and L3, respectively. In this way, a three-dimensional circuit block 40 where parts each to be finally three-dimensional sensing module 1 are arranged in a row is manufactured.

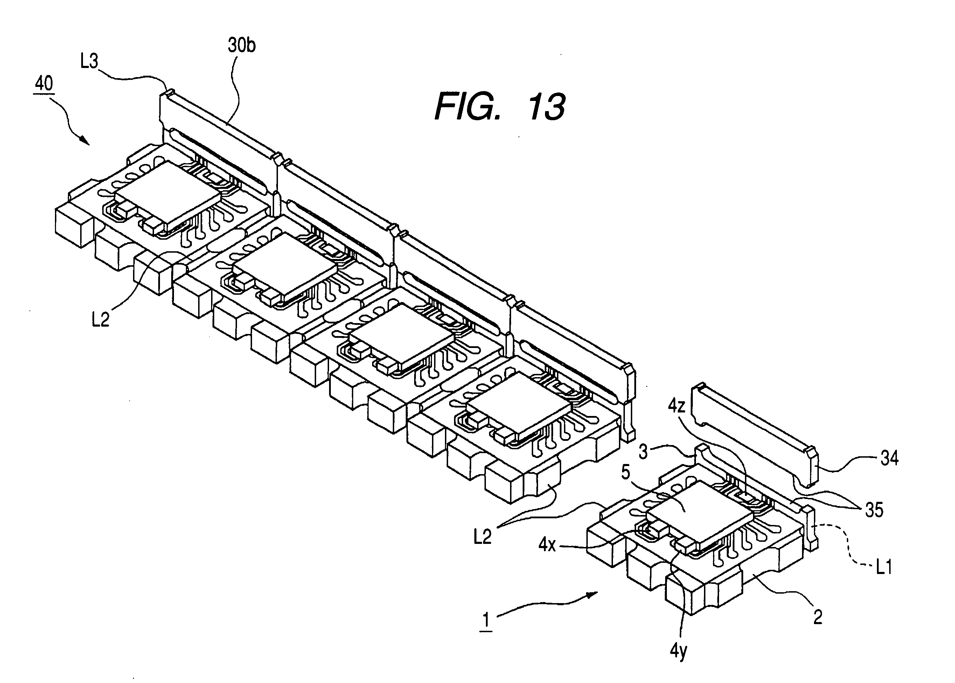

In the dividing process, as shown in Fig. 13, the three-dimensional block 40 is cut along the second slits 22 and the fourth slits 32. Further, the remaining parts 34 are cut along the fifth slits 35. At this time, since the second slits 22 and the fourth slits 32 are formed into perforated line shapes, it is possible to easily cut the three-dimensional block along the boundary lines L2 and L4. Furthermore, it is possible to easily cut between the connection parts 33 and the remaining parts 34 along the fifth slits 35. In this way, it is possible to divide the three-dimensional circuit block 40 into individual three-dimensional sensing modules 1. Then, after removing burrs (unnecessary protrusions) remaining on edges of the divided three-dimensional sensing modules 1, the top of the first wiring board 2 where the second wiring board 3 is bonded is sealed by the sealant 9. The sealant 9 can include, for example, an epoxy resin, etc.

It is possible to manufacture a plurality of three-dimensional sensing modules 1 through the above-mentioned processes at once. Further, the size of the manufactured three-dimensional sensing module 1 is, for example, 3 mm x 3 mm x 1 mm.

As described above, in the method of manufacturing a three-dimensional sensing module 1 according to the invention, it is possible to accurately manufacture the three-dimensional sensing modules 1 each having a remarkably reduced size at once without passing through complicated processes.

Further, in the method of manufacturing a three-dimensional sensing module 1, it is possible to use a general apparatus for forming the first and second wiring patterns 2a and 3b or for mounting the magnetic sensors 4x, 4y, and 4z and the IC chip 5, it is possible to prevent an increase in the manufacturing cost.

Furthermore, in the method of manufacturing a three-dimensional sensing module, it is possible to sequentially repeat the above-mentioned bonding process, the three-dimensional circuit block manufacturing process, and the dividing process. In particular, it is possible to repeat the manufacturing process of the three-dimensional circuit block 40 from the first and second mother wiring boards 20 and 30 which are cut in the bonding process and the dividing process of dividing the three-dimensional circuit block 40 into the individual three-dimensional modules 1. In this way, it is possible to effectively manufacture the three-dimensional sensing module 1 and it is possible to remarkably improve the productivity.

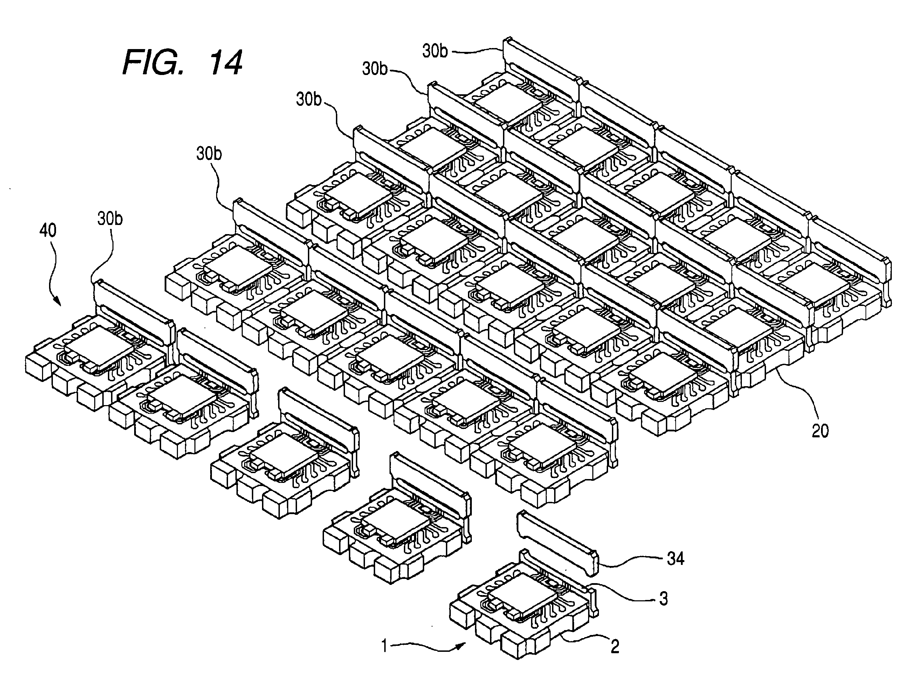

In addition, the method of manufacturing a three-dimensional circuit module according to the invention is not limited to the above-mentioned manufacturing processes. The method of manufacturing a three-dimensional circuit module may have a process of cutting a row board 30b, where parts each to be the second wiring board 3 are formed in a row, from the second mother wiring board 30, for example, as shown in Fig. 14, as another process. Further, it is possible to perform the bonding process and the dividing process by using the row board 30b.

In particular, first, the row board 30b where the parts each to be the second wiring board 3 are formed in a row is separated from the second mother wiring board 30 by cutting the second mother wiring board 30 along the third slits 31 before the bonding process.

Subsequently, in the bonding process, the plurality of row boards 30b are disposed with respect to the first mother wiring board 20 along the individual boundary lines L1 in the first direction and are bonded to the first mother wiring board 20 at 90°. In particular, the connection parts 34 of the row boards 30b which extend from the third slits 31 of the individual cutting surfaces along the boundary lines L3 are engaged with the second notched concave parts 7 along the boundary lines L1 of the first mother wiring board 20 such that the magnetic sensors 4z mounted on the connection parts 34 are disposed in the second notched concave parts 7. Then, the row boards 30b are bonded to the first mother wiring board 20 at 90° by an adhesive which is coated on the bonded part between the first mother wiring board 20 and the row boards 30b in advance. In this way, the plurality of row boards bonded to the first mother wiring board 30 at 90° are arranged along the boundary lines L1, respectively.

Next, in the three-dimensional circuit block manufacturing process, the parts of the first mother wiring board 20 bonded to each row board 30b is separated from the first mother wiring board 20 by cutting along the first slits 21 of the bonded portion. In this way, it is possible to manufacture a plurality of three-dimensional blocks 40 each where the parts each to be finally the three-dimensional sensing module 1 are arranged in a row.

Next, in the dividing process, the plurality of three-dimensional circuit blocks 40 are cut out along the second slits 22 and the fourth slits 32. Further, the remaining parts 34 are cut out along the fifth slits 35. In this way, it is possible to divide the three-dimensional circuit blocks 40 into the individual three-dimensional sensing modules 1. Then, after removing burrs (flash; fin, unnecessary protrusions) remaining on edges of the divided three-dimensional sensing module 1, the top of the first wiring board 2 where the second wiring board 3 is bonded is sealed by the above-mentioned sealant 9.

It is possible to manufacture a plurality of three-dimensional sensing modules 1 through the above-mentioned processes at once. Further, even in this case, it is possible to accurately manufacture the three-dimensional sensing modules 1 each having a reduced size at once without passing through complicated processes. Therefore, it is possible to reduce the manufacturing cost.

Further, the row board 30b is not limited to the above board which is cut from the second mother board 30, but can be directly manufactured where parts each to be the second wiring board formed in a row. Furthermore, in the first mother wiring board 20, the second mother wiring board 30, and the row board 30b, the number of the parts to be the first or second wiring boards 2 or 3 arranged in the vertical or horizontal direction is arbitrary. In addition, it is possible to arbitrarily change the order in which the boards 20, 30, and 30b are divided or bonded.

The invention can be applied to a three-dimensional circuit module having a three-dimensional structure in which a second board is bonded to a first board at a predetermined angle and a method of manufacturing the same as well as the above-mentioned three-dimensional sensing module 1.

Further, the invention is not limited to the three-dimensional circuit module in which the second board is boned to the first board at 90° but can provide a three-dimensional circuit module in which a second board is bonded to a first board at an angle other than 90° by changing the angle of a bonding surface of the first board. Even in this case, it is possible to correct the angle of the bonding surface of the first board with high precision by forming at least the first board of the first and second boards by injection molding.

As described above, in the three-dimensional circuit module according to the invention, it is possible to precisely and easily perform the angle correction of the electronic components when bonding the second board at a predetermined angle to the first board and it is further possible to reduce the entire module size.

Further, in the method of manufacturing a three-dimensional circuit module according to the invention, it is possible to accurately manufacturing a plurality of small-sized three-dimensional circuit modules at once without performing complicated processes, and thus it is possible to reduce the manufacturing cost.

## Claims

1. A three-dimensional circuit module which includes a first board and a second board each having at least one surface with wiring lines formed thereon and has a three-dimensional structure in which the second board is bonded to the first board at a predetermined angle so as to form a wiring circuit in which the wiring lines of the first and second boards are connected to each other,
wherein the first board has a first notched concave part formed at an edge to be a bonding surface and a second notched concave part formed at an edge of the first notched part in the depth direction of the first notched part,
the second board has an electronic component mounted on an surface opposite to the bonding surface of the first board, and
the second board is engaged with the first notched concave part in a state in which the electronic component is disposed in the second notched concave part.

2. The three-dimensional circuit module according to claim 1,
wherein the bonding surface of the first board and a bonding surface of the second board are bonded to each other by an adhesive.

3. The three-dimensional circuit module according to claim 1 or 2,
wherein metal bump or conductive paste is provided to the boundary where the wiring lines on the bonding surface of the first board and the wiring lines on the bonding surface of the second board are brought into contact with each other, and electrically connect the wiring lines of the first board and the wiring lines of the second board to each other.

4. The three-dimensional circuit module according to any of claims 1 to 3,
wherein at least the first board of the first and second boards is formed by injection molding.

5. The three-dimensional circuit module according to any of claims 1 to 4,
wherein the first board is thicker than the second board.

6. The three-dimensional circuit module according to any of claims 1 to 5,
wherein the surfaces of the first and second boards on which the wiring lines are formed are flat.

7. The three-dimensional circuit module according to any of claims 1 to 6,
wherein the predetermined angle is 90°.

8. A method of manufacturing a three-dimensional circuit module which includes a first board and a second board each having at least one surface with wiring lines formed thereon and has a three-dimensional structure in which the second board is bonded to the first board at a predetermined angle so as to form a wiring circuit in which the wiring lines of the first and second boards are connected to each other, the method comprising the steps of:
forming a first mother board where a plurality of parts each to be the first board are arranged in a matrix by forming the wiring lines on every part to be the first board, forming first slits at predetermined intervals along boundary lines where the parts to be the first boards are parallel to a first direction, and second slits at predetermined intervals along boundary lines where the parts to be the first boards are parallel to a second direction perpendicular to the first direction, and forming a first notched concave part at an edge on the side to be bonding surface of each first board and a second notched concave part at an edge of each first notched concave part in the thickness direction of the first notched concave part;
forming a second mother board where a plurality of parts each to be the second board are arranged in a matrix by forming the wiring lines on every part to be the second board, forming third slits at predetermined intervals along boundary lines where the parts to be the
second boards are parallel to a third direction, and fourth slits at predetermined intervals along boundary lines where the parts to be the second boards are parallel to a fourth direction perpendicular to the third direction, and mounting an electronic component at each part to be the second board;
bonding the second mother board to the first mother board at a predetermined angle in a state in which the parts of the second mother board to be the second boards are engaged with the first notched concave parts such that the electronic components are disposed in the second notched concave parts;
forming a three-dimensional circuit block where three-dimensional circuit modules are arranged in a row by cutting out a part of the first mother board bonded to the second mother board along the first slits of the bonded part from the first mother board and cutting out the part of the second mother board bonded to the first mother board along the third slits form the second mother board; and
dividing the three-dimensional circuit block into individual three-dimensional circuit modules by cutting the three-dimensional circuit block along the second and fourth slits.

9. The method of manufacturing a three-dimensional circuit module according to claim 8,
wherein, before the bonding step, at least a row
board where the parts of the second mother board to be the second boards are arranged in a row is cut out along the third slits from the second mother board;
in the bonding step, the row board is bonded to the first mother board at a predetermined angle in a state in which the parts of the row board to be the second boards are engaged with the first notched concave parts such that the electronic components are disposed in the second notched concave parts; and
in the three-dimensional circuit block forming step, the three-dimensional block is formed by cutting out the part of the first mother board bonded to the row board along the first slits of the bonded part from the first mother board.

10. The method of manufacturing a three-dimensional circuit module according to claim 8 or 9,
wherein the bonding step, the three-dimensional circuit block forming step, and the dividing step are sequentially repeated.

11. The method of manufacturing a three-dimensional circuit module according to any of claims 8 to 10,
wherein, in the first mother board forming step, the first slits are formed between the boundary lines parallel to the second direction.

12. The method of manufacturing a three-dimensional
circuit module according to any of claims 8 to 11,
wherein, in the second mother board forming step, the third slits are formed at both sides of each of the parts to be the second boards.

13. The method of manufacturing a three-dimensional circuit module according to any of claims 8 to 12,
wherein protrusions are formed between the first slits such that the protrusions are brought into contact with the surfaces of the parts to be the second boards opposite to the surfaces on which the electronic components are mounted when the parts to be the second boards are engaged with the first notched concave parts.

14. The method of manufacturing a three-dimensional circuit module according to any of claims 8 to 13,
wherein, in the bonding step, the first mother board is bonded to the second mother board or the row board by an adhesive.

15. The method of manufacturing a three-dimensional circuit module according to any of claims 8 to 14,
wherein, in the bonding step, metal bump or conductive paste is formed at the boundary where the wiring lines on the bonding surface of the first board and the wiring lines on the bonding surface of the second board are brought into contact with each other, and electrically connects the wiring lines of the first board
and the wiring lines of the second board to each other.

16. The method of manufacturing a three-dimensional circuit module according to any of claims 8 to 15,
wherein at least the first mother board of the first and second mother boards is formed by injection molding.

17. The method of manufacturing a three-dimensional circuit module according to any of claims 8 to 16,
wherein the first mother board is thicker than the second mother board.

18. The method of manufacturing a three-dimensional circuit module according to any of claims 8 to 17,
wherein the surfaces of the first and second mother boards on which the wiring lines are formed are flat.

19. The method of manufacturing a three-dimensional circuit module according to any of claims 8 to 18,
wherein, in the bonding step, the predetermined angle is 90°.
